# EUROPEAN PATENT APPLICATION

(11) **EP 4 823 310 A1**
(43) Date of publication of application: **14.10.2026**
(21) Application number: 26169001.0
(22) Date of filing: 30.03.2026
(51) Int. Cl.: H10W 90/00, H10W 72/00, H10W 72/20

(54) **MICROELECTRONICS PACKAGE WITH HYBRID CONNECTION TO A SUBSTRATE TO ENABLE REUSE**

(30) Priority: 07.04.2025 US 202519172032
(71) Applicant: NXP B.V., 5656 AG Eindhoven (NL)
(72) Inventor: Mavinkurve, Amar Ashok, 5656 AG Eindhoven (NL); Terzariol, Greta, 5656 AG Eindhoven (NL)
(74) Representative: Schmütz, Christian Klaus Johannes

(57) **Abstract**

A method includes providing a circuit substrate including an active surface including one or more protrusions formed from a first material with a first melt temperature; coating each of the one or more protrusions with a second material having a second melt temperature that is less than the first melt temperature; and pressing a semiconductor device die onto the circuit substrate to form a circuit assembly, where the die includes one or more cavities aligned with the protrusions. Each die is plated with a third material having a third melt temperature that is greater than the second melt temperature. The method includes heating the circuit assembly at a selected temperature that is greater than or equal to the second melt temperature and that is less than the first and third melt temperatures to reflow the second material to form an intermetallic connection between the substrate and the die.

## Description

### FIELD OF USE

The present disclosure generally relates to semiconductor packages, and more particularly to a microelectronics package with a hybrid connection to a substrate, such as a printed circuit board, to enable mechanical and electrical coupling and subsequent separation for reuse.

### BACKGROUND

In certain types of semiconductor device packaging, semiconductor device die contact terminals may be electrically and mechanically coupled to a package substrate interconnect, such as a contact pad of a printed circuit board (PCB). Traditional methods of coupling the semiconductor device die to the substrate involve a solder reflow operation using solder bumps or solder-tipped metal columns formed on contacts of the semiconductor device die to contacts on the package substrate interconnect. Such solder reflow operations involve heating at least the contact region to temperatures sufficient to cause the solder to flow.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1 depicts a flow diagram of a method of coupling a semiconductor device die to a circuit substrate, in accordance with certain embodiments.
FIG. 2A depicts a process of forming a circuit substrate including electrically conductive protrusions formed from a first metal having a first melt temperature and coated with a second metal having a second melt temperature, in accordance with certain embodiments.
FIG. 2B depicts a process of providing a semiconductor device die including cavities sized to receive the conductive protrusions of the circuit substrate, in accordance with certain embodiments.
FIG. 3 depicts a process of mechanically and electrically coupling the semiconductor device die to the circuit substrate, in accordance with certain embodiments.
FIG. 4 depicts a flow diagram of a method of mechanically and electrically decoupling the semiconductor device die from the circuit substrate, in accordance with certain embodiments.
FIG. 5 depicts a process of using heat and force to mechanically and electrically decouple the semiconductor device die from the circuit substrate, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

Reflow processes for lead-free solder bumps and solder-tipped metal columns have been known to cause dielectric delamination under the bumps or metal columns, which may be due to differences in the coefficients of thermal expansion between the semiconductor device die material and the circuit substrate material. During the solder reflow process, localized heating is used to melt and reflow the solder and, subsequently, high stresses may occur in the interconnect region causing the delamination. Even when the reflow process does not cause such delamination, subsequent heating to remove a semiconductor device die from the circuit substrate may cause such delamination as well as other damage to the semiconductor device die, the circuit substrate, or both.

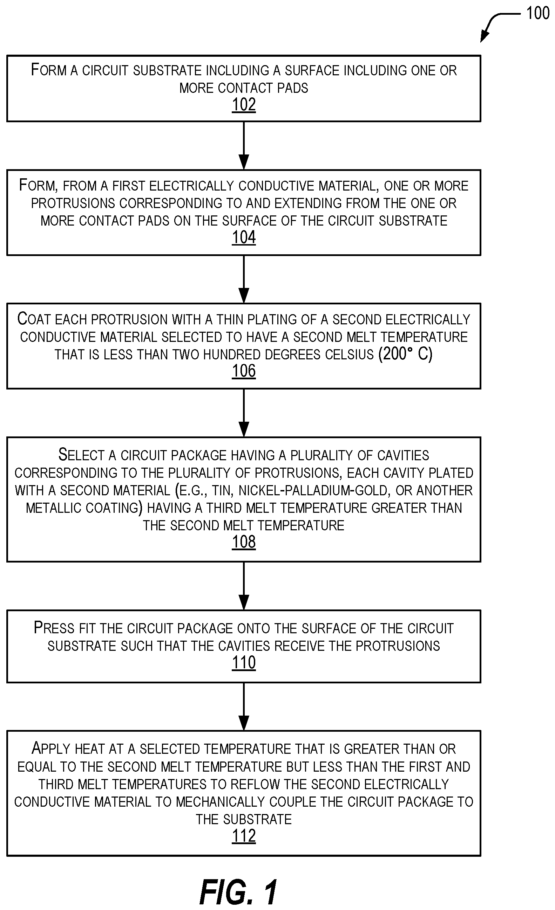

Embodiments of methods of electrically and mechanically coupling a semiconductor device die to a circuit substrate are described below that enable reversable coupling in microelectronics packages. In one or more embodiments, the methods utilize a hybrid connection between the semiconductor device package and the circuit substrate (such as a PCB) using a mechanical "click-fit" type of connection in combination with a soft intermetallic connection between plated leads of the semiconductor device die and protrusions (studs) on the circuit substrate. In the following discussion of FIGs. 1-5, the methods and processes are described with respect to a QFN (quad flat no leads) package; however, the methods and processes are not limited to leadless packages. The methods and processes may similarly be applied to leaded packages, such as QFP (quad flat package) devices, SO (small outline) devices, and other types of packages to be coupled to a circuit substrate. In other embodiments, the methods and processes may be applied to ball grid array (BGA) packages and bumped packages where the cavities may be added to the copper traces or the redistribution layer (RDL) instead of solder ball connections.

FIG. 1 depicts a flow diagram of a method 100 of coupling a semiconductor device die to a circuit substrate, in accordance with certain embodiments. At 102, the method 100 may include forming a circuit substrate including a surface including one or more contact pads. The circuit substrate may be a lead frame, a printed circuit board (PCB), a semiconductor device die, or another substrate.

At 104, the method 100 may include forming, from a first electrically conductive material, one or more protrusions corresponding to and extending from the one or more contact pads on the surface of the circuit substrate. In one or more embodiments, the protrusions (sometimes referred to as "studs" or "posts") may be formed on the circuit substrate by plating, mechanical processing, or other processes that are known in the art. The first electrically conductive material may be selected from a copper alloy plated with one or more of Nickel (Ni), Palladium (Pd), Gold (Au), and Tin (Sn); Aluminum (Al); solder; or other electrically conductive material having a melt temperature that is greater than two hundred degrees Celsius (200° C). In one or more embodiments, the protrusions may have a cylindrical shape, a pyramidal shape, a semi-circular shape, a rectangular shape, or another shape. In one or more embodiments, each protrusion may include a first portion having a first shape having a proximal end coupled to one of the contact pads and having a distal end and may include a second portion having a rounded shape that is coupled to or formed on the distal end of the protrusion.

At 106, the method 100 may include coating each protrusion with a thin plating of a second electrically conductive material selected to have a second melt temperature that is less than 200° C. The second electrically conductive material may be Gallium (Ga), Bismuth (Bi), Indium (In), or another electrically conductive material that has a melt temperature in a range of one hundred degrees Celsius (100° C) to 200° C. The thickness of the plating may vary based on the implementation. In one or more embodiments, process optimization may be used to define an optimum combination of fitting tolerance, plating thicknesses, and shapes. In one or more embodiments, the environment in which the circuit device is to be used may also be taken into account.

At 108, the method 100 may include selecting a circuit package having a plurality of cavities corresponding to the plurality of protrusions, each cavity plated with a third material (e.g., tin, nickel-palladium-gold, or another electrically conductive) having a third melt temperature greater than the second melt temperature. In one or more embodiments, the circuit package may be selected by a pick-and-place machine. In one or more embodiments, the third melt temperature of the plating within the cavities may be similar to the first melt temperature of the protrusions (e.g., greater than 200° C) and may be greater than the second melt temperature of the coating applied to the protrusions. Each cavity may have a size and a shape that is selected to receive a corresponding protrusion on the circuit substrate (PCB) to enable a mechanical and electrical connection.

At 110, the method 100 may include press fitting the circuit package onto the surface of the circuit substrate such that the cavities receive the protrusions. In one or more embodiments, the cavities of the circuit package may be aligned to the protrusions and the circuit package may be press fit onto the protrusions.

At 112, the method 100 may include applying heat at a selected temperature that is greater than or equal to the second melt temperature but less than the first and third melt temperatures to reflow the second electrically conductive material to mechanically couple the circuit package to the substrate. The heat may be applied at a relatively low temperature that is sufficiently high to cause the second electrically conductive material to melt and reflow and then to cool to mechanically and electrically couple the circuit package to the circuit substrate. In one or more embodiments, after heating and reflow of the second electrically conductive material, a mechanical bond is formed between the circuit package and the circuit substrate that is strong enough to sustain intermediate mechanical loads or vibrations. The electrical connection may be reliably formed by the relatively low-temperature reflow process that may enable an electromechanical bond between the third electrically conductive material within the cavities of the circuit package and the second electrically conductive material.

The lower melt temperature of the second electrically conductive material may enable reflow coupling of the circuit package to the circuit substrate at a temperature that does not thermally stress areas of the electrical connections and that does not cause delamination of the dielectric material. Moreover, the lower melt temperature may enable subsequent removal of the circuit package from the circuit substrate using heat and mechanical force to enable recycling/reuse of the circuit package in conjunction with a different circuit substrate. Due to an increasing interest in more sustainable electronics, the hybrid, lower-temperature electromechanical connection enabled by the second electrically conductive material may enable reuse, recycle and repair of circuit packages. To enable reuse of microelectronics packages (e.g., removing them from existing applications, such as removing them from PCBs, that are used in systems that perform relatively critical tasks (such as a self-driving vehicle)) to remount them to a different PCB for use in less critical applications, the second electrically conductive material enables attachment and subsequent removal of the circuit package without damaging the circuit substrate or the circuit package.

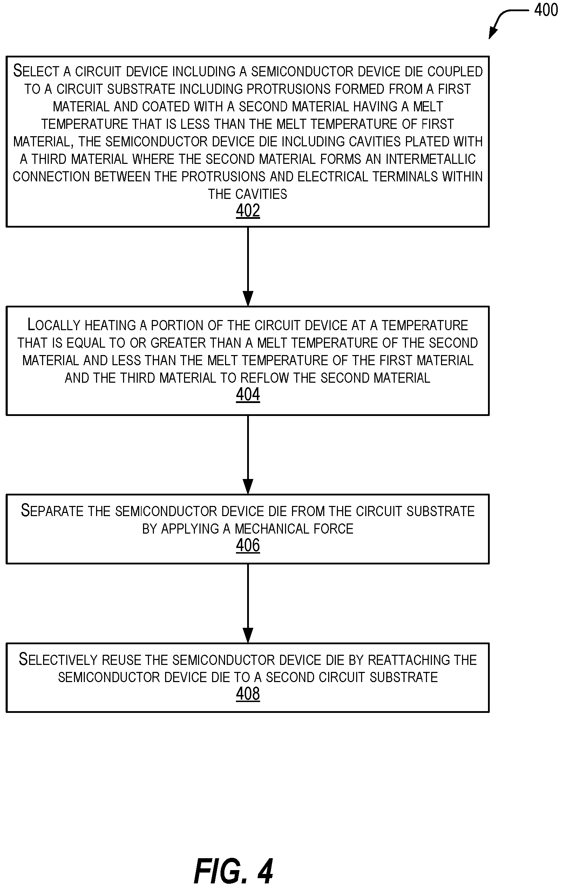

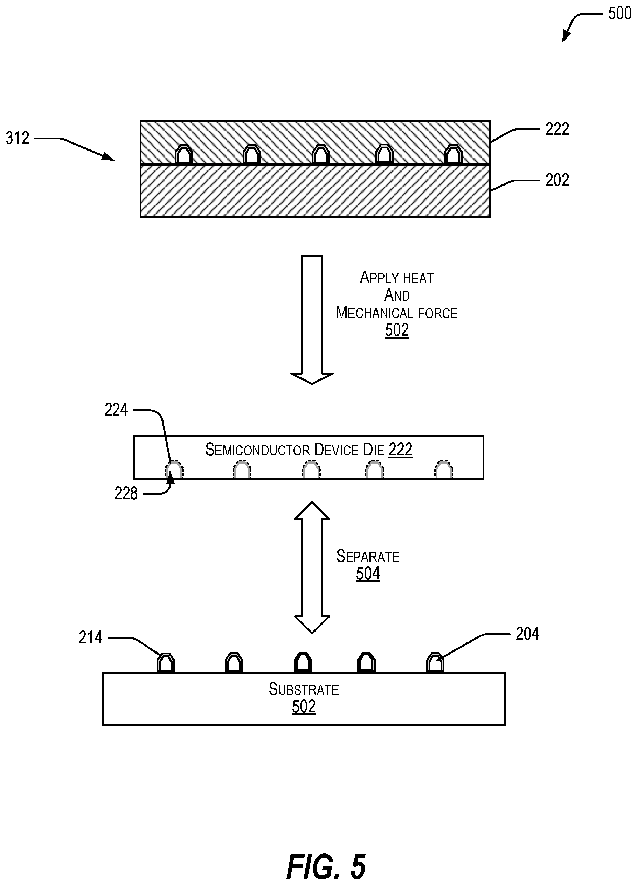

Removal is facilitated with a relatively mild heating step and application of mechanical forces (as discussed with respect to FIGs 4 and 5 below). The separated circuit package may be reconnected on another PCB using the same method as the original connection (e.g., method 100 in FIG. 1). Such connections can be made on the leads or the die pad. In some cases, a reworkable Thermal Interface Material (TIM) can be used to reduce the thermal resistance at the interface to the circuit substrate.

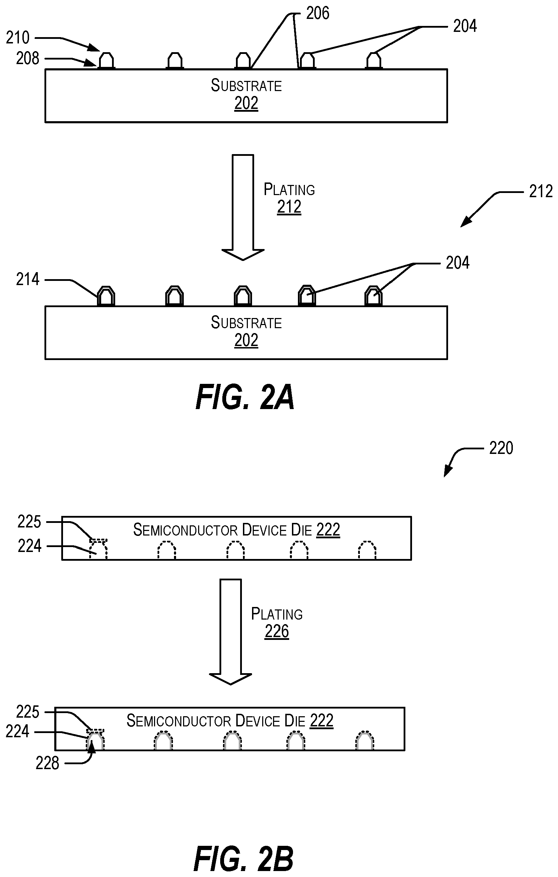

In the following discussion, an illustrative process flow is described with respect to FIGs. 2A-3. It should be understood that the representations in FIGs. 2A-3 are for illustrative purposes only and are not drawn to scale. In the following discussions, some representative dimensions are provided for illustrative purposes, but it should be appreciated that the methods and processes described may be applied to different geometries as well.

FIG. 2A depicts a process 200 of forming a circuit substrate 202 including electrically conductive protrusions 204 formed from a first electrically conductive material having a first melt temperature and coated with a second electrically conductive material 214 having a second melt temperature, in accordance with certain embodiments. In one or more embodiments, the circuit substrate 202 may include multiple layers including dielectric layers and patterned metal layers (not shown). In the illustrative example, the circuit substrate 202 may include a plurality of protrusions 204 (studs or posts) formed on metal contacts 206 on the surface of the circuit substrate 202. In one or more embodiments, the circuit substrate 202 may be a printed circuit board (PCB), a lead frame, or other substrate.

In the illustrated example, each protrusion 204 may include a first portion 208 and a second portion 210. The first portion 208 is depicted as having a cylindrical or rectangular shape (in a side view). In one or more embodiments, the first portion 208 may have a conical shape, a cylindrical shape a rectangular shape, a circular shape, a pyramidal shape, or another shape. In one or more embodiments, the first portion 208 may have a proximal end coupled to one of the contact pads 206 and may have a distal end.

The second portion 210 may be coupled to the distal end of the protrusion 204. In the illustrated embodiment, the second portion 210 may include a tapered shape, such as a conical shape. In other embodiments, the second portion 210 may have a conical shape, a rounded shape, a cylindrical shape, a rectangular shape, a circular shape, a pyramidal shape, or another shape. The second portion 210 may have or may taper to a narrower profile or may otherwise be smaller than the first portion 208. In one or more embodiments, the second portion 210 may be narrower than the first portion 208 to assist in alignment of the protrusion 204 to a corresponding cavity (cavity 224 in FIG. 2B) formed in the semiconductor device die.

While the protrusions 204 in the illustrated example include a first portion 208 and a second portion 210, in one or more embodiments, the second portion 210 may be omitted, and the first portion 208 may be tapered from the proximal end to the distal end. Other implementations are also possible. In the illustrated example, the protrusions 204 are depicted as having a substantially symmetrical shape to facilitate insertion of the protrusions 204 into the cavities in the semiconductor device die. In one or more other embodiments, the protrusions 204 may be at least slightly asymmetrical. Preferably, a distal end (the end of the protrusion 204 that is furthest from the surface of the circuit substrate 202) may be narrower than the proximal end to facilitate insertion of the protrusion 204 into the cavity.

As shown, a plating process 212 may be used to apply a second electrically conductive material 214 on the protrusions 204 as generally indicated at 212. The second electrically conductive material 214 may include Bismuth, Indium, or another material having a melt temperature below 200° C. The plating process 212 may apply the second electrically conductive material 214 as a thin layer over the protrusion 204 such that the thickness of the second electrically conductive material 214 added to the thickness of the protrusion 204 may still fit within the cavity of the circuit package.

FIG. 2B depicts a process 220 of providing a semiconductor device die 222 including cavities 224 sized to receive the conductive protrusions 204 of the circuit substrate 202, in accordance with certain embodiments. In one or more embodiments, the cavities 224 may be formed by laser, etching, or other mechanical or chemical processes. In one or more embodiments, the cavities 224 may be formed as part of the layer-by-layer metal/dielectric buildup of the semiconductor device die 222. One or more of the cavities 224 may include an electrically conductive terminal, such as the electrically conductive terminal 225, configured to couple electrical signals to metal layers (not shown) within the semiconductor device die 222. In one or more embodiments, one or more of the cavities 224 may include the electrically conductive terminal 225.

In one or more embodiments, the cavities 224 may be plated by a plating process 226 with a third electrically conductive material 228 that has higher melting temperature than the second electrically conductive material 214 applied to the protrusions 204 on the circuit substrate 202. The third electrically conductive material 228 may include Tin (Sn), Nickel-Palladium-Gold (NiPdAu), Copper (Cu), or other electrically conductive material having a melting temperature that is above 200° C. In one or more embodiments, the third electrically conductive material 228 may be the same or similar to the first electrically conductive material from which the protrusions 204 may be formed. In the illustrated example, the third electrically conductive material 228 may facilitate an electrical connection to the electrically conductive terminal 225 within the cavity 224.

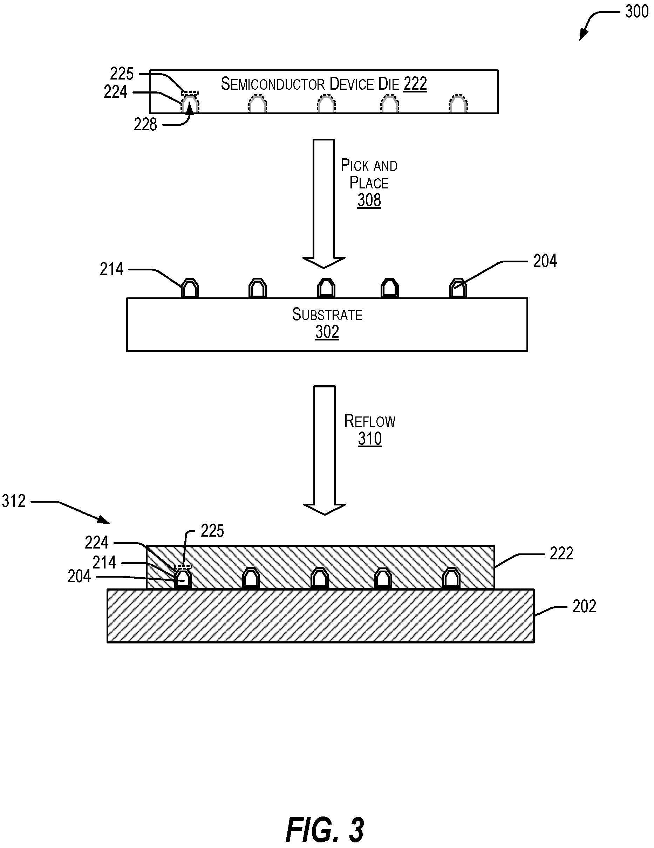

FIG. 3 depicts a process 300 of mechanically and electrically coupling the semiconductor device die 222 to the circuit substrate 202 to form a circuit device, in accordance with certain embodiments. In the illustrated example, the semiconductor device die 222 may be picked and placed 308 onto the circuit substrate 202. In one or more embodiments, the pick and place operation 308 may be performed by a machine. The cavities 224 of the semiconductor device die 222 may be aligned to the protrusions 204 with the second electrically conductive material 214 applied as a coating. In one or more embodiments, the second portions 210 of the protrusions 204 may be narrower than the first portions 208 of the protrusions 204, which may facilitate insertion of the protrusions 204 into the cavities 224. In one or more embodiments, the initial attachment may be a press fit or click fit.

In one or more embodiments, a reflow process 310 may be applied, such as by locally heating the second electrically conductive material 214 to a melt temperature that is below the melt temperature of the protrusions 204. Such local heating may be provided using lasers or other localized heating sources. The local heating causes the second electrically conductive material to flow and to form an intermetallic connection with the third electrically conductive material 228 within the cavities 224 of the semiconductor device die 222, producing a circuit assembly, which is generally indicated at 312.

In the illustrated example, the circuit assembly 312 is shown in cross-section to show the electromechanical connections formed by the protrusions 204 and the cavities 224 to secure the semiconductor device die 222 to the circuit substrate 202. In the illustrated example, the circuit substrate 202 and the semiconductor device die 222 are depicted in two dimensions, but it should be understood that the circuit substrate 202 and the semiconductor device die 222 are three-dimensional objects. In one or more embodiments, the protrusions 204 may be arranged in a row. In one or more embodiments, the protrusions 204 may be distributed in an array. In the illustrated example, five protrusions 204 are depicted; however, the circuit substrate 202 may include any number of protrusions 204. Further, while the circuit substrate 202 is shown as being coupled to only one semiconductor device die 222, it should be appreciated that the circuit substrate 202 may support any number of semiconductor device dies 222 using the methods described herein.

In one or more embodiments, the local heating is at a temperature that corresponds to the melt temperature of the second electrically conductive material 214 that is below the melt temperatures of the protrusions 204 (the first electrically conductive material) and below the melt temperature of the third electrically conductive material 228, or an intermediate temperature due to the presence of intermetallic compounds. Thus, the mechanical and electrical coupling between the semiconductor device die 222 and the circuit substrate 202 is produced at a temperature that does not produce thermal stresses with respect to dielectric material near the conductive terminals within the semiconductor device die 222 or with respect to dielectric material near the protrusions 204 of the circuit substrate 202. Accordingly, thermal stresses are avoided that might otherwise cause delamination.

The relatively low melt temperature of the second electrically conductive material 214 may facilitate intermetallic connection with the plating material (third electrically conductive material 228) within the cavities 224 of the semiconductor device die 222. Further, the low melt temperature may also enable decoupling of the semiconductor device die 222 from the circuit substrate 202, allowing for reuse of the semiconductor device die 222 with another circuit substrate.

FIG. 4 depicts a flow diagram of a method 400 of mechanically and electrically decoupling the semiconductor device die from the circuit substrate, in accordance with certain embodiments. It should be appreciated that the method 400 may be performed subsequent to or at a later time relative to the methods and processes described with respect to FIGs. 1-3.

At 402, the method 400 may include selecting a circuit device 312 including a semiconductor device die 222 coupled to a circuit substrate 202 including protrusions 204 formed from a first material and coated with a second electrically conductive material 214 having a melt temperature that is less than the melt temperature of first material, the semiconductor device die 222 including cavities 224 plated with a third electrically conductive material 228 where the second electrically conductive material 214 forms an intermetallic connection between the protrusions 204 and electrical terminals 225 within the cavities 224. The circuit device 312 may be an embodiment of the circuit assembly 312 in FIG. 3.

At 404, the method 400 may include locally heating a portion of the circuit device 312 at a temperature that is equal to or greater than the melt temperature of the second material 214 and less than the melt temperature of the first material and the third material to reflow the second material 214. In an embodiment, the local heating may be performed at a temperature that is between 100°C and 200°C, while the melt temperatures of the first material and the third material may be greater than 200°C. In one or more embodiments, the local heating may be directed at the junction between the semiconductor device die 222 and the circuit substrate 202.

At 406, the method 400 may include separating the semiconductor device die 222 from the circuit substrate 202 by applying mechanical force. The combination of the applied mechanical force and the localized heating may separate the semiconductor device die 222 from the circuit substate 202.

At 408, the method 400 may selectively reuse the semiconductor device die 222 by reattaching the semiconductor device die 222 to a second circuit substrate 408. In one or more embodiments, the separated semiconductor device die 222 may be connected on a different circuit substrate or printed circuit board that includes protrusions 204 and the second material 214 using the process described above with respect to FIGs. 1-3.

Due to the electromechanical interference fit, deformations of the softer, lower melt-temperature material (second electrically conductive material 214) does not create an issue during reassembly and reconnection to a new circuit substrate 202. In contrast to solder, which is typically used to couple a semiconductor device die 222 to a circuit substrate 202 and which has a melt temperature between 230° C and 260° C, the second electrically conductive material 214 may have a melt temperature that is below 200° C, enabling remelt and separation of the semiconductor device die 222 at a temperature that is below a melt temperature of other conductive metal connections.

FIG. 5 depicts a process 500 of using heat and force to mechanically and electrically decouple the semiconductor device 222 die from the circuit substrate 202, in accordance with certain embodiments. The process 500 includes a selected circuit device (circuit assembly) 312 including a semiconductor device die 222 coupled to a circuit substrate 202.

At 502, heat and mechanical force are applied. The heat may be localized heat directed at the interface between the circuit substrate 202 and the semiconductor device die 222. Concurrently with applying the localized heat, a mechanical force may be applied to separate the circuit die 222 and the circuit substrate 202. Once the local heating melts or otherwise weakens the intermetallic connection between the second electrically conductive material and one or more of the protrusions 204 or the plating (the third electrically conductive material 228 within the cavities 224, the mechanical force may separate 504 the semiconductor device die 222 from the circuit substrate 202. The separated semiconductor device die 222 may then be repurposed and reused.

In one or more embodiments, the separated semiconductor device die 222 may be coupled to a different circuit substrate 202 to form a new circuit assembly 312. The circuit substrate 202 from which the semiconductor device die 222 was separated may also be reused with a different semiconductor device die 222. In one or more embodiments, the hybrid connection may enable replacement of a semiconductor device die 222 with an upgraded semiconductor device die. Further, the removed semiconductor device die 222 may be used with a different circuit substrate 202.

Thus, the hybrid connection may enable more sustainable electronics by enabling repair, recycle, and reuse for semiconductor devices. In one or more embodiments, a semiconductor device die 222 may be removed from an existing application, such as from a printed circuit board (PCB) used in a critical application (e.g., self-driving automobile functionality), and remounted for reuse in a less critical application. Thus, semiconductor device dies 222 may be attached and subsequently detached from PCBs without damaging the semiconductor device die 222 or the circuit substrate 202 because the local heat used to separate them is at a low temperature relative to other metal traces, such as the contact pads 206 of the circuit substrate 202. The removed semiconductor device die 222 may be easily reconnected on another PCB using the same method 100 as the original connection.

In the above-discussion of FIGs. 1-5, the semiconductor device die 222 is depicted as a quad-flat no-lead package that couples to the circuit substrate 202 using a click-fit or press-fit type of connection in combination with the low-temperature intermetallic connection between the plated leads within cavities 224 of the package and protrusions 204 of circuit substrate 202. However, the methods and processes described herein may also be used to packages with leads, such as a quad-flat package with leads, a small outline package, or other circuit device packages.

In conjunction with the processes and methods described above with respect to FIGs. 1-5, a method of forming a circuit device 312 may include forming a circuit substrate 202 including a plurality of protrusions 204 (studs or pillars) formed from a first material having a first melt temperature and coating each of the protrusions 204 with a second material 214 having a second melt temperature that is less than the first melt temperature. The method may include plating cavities 224 in a surface of a semiconductor device die 222 with a third material 228 having a third melt temperature that is greater than the second melt temperature. The method may include aligning the cavities 204 of the semiconductor device die 222 with the protrusions 204 of the circuit substrate 202 and pressing or clicking them together. The method may include locally heating at least one of an interface between the semiconductor device die 222 and the circuit substrate 202 and the protrusions 204 at a selected temperature that is greater than or equal to the second melt temperature and that is less than the first and third melt temperatures to reflow the second material to form an intermetallic connection between the semiconductor device die 222 and the circuit substrate 202.

In one or more embodiments, the semiconductor device die 222 may be separated from the circuit substrate 202 by applying localized heat and mechanical force to break the intermetallic connection without damaging the semiconductor device die 222 or the circuit substrate 202. The separated semiconductor device die 222 may then be repurposed and reused with a different circuit substrate using the process described above to produce a new circuit device.

In one or more embodiments, the methods and processes described above with respect to FIGs. 1-5 include replacing the solder connection of a conventional circuit device with a mechanical interlocking to mount the packaged active device (semiconductor device die 222) on top of the circuit substrate 202 (chip-to-board connection). Conventional solder joints and other types of attachments, such as direct attach (DA) are replaced by a mechanical connection joint and a low temperature electrically conductive material (such as a low-temperature solder), for a reliable galvanic connection. According to the embodiments described herein, the packaged device (e.g., the semiconductor device die 222) can be detached from the PCB (circuit substrate 202) and eventually reused for other applications. This disclosure may be further understood in light of the following examples.

Example 1: A method includes providing a circuit substrate including an active surface including one or more protrusions, each protrusion formed from a first material having a first melt temperature; coating each of the one or more protrusions with a second material having a second melt temperature that is less than the first melt temperature; pressing a semiconductor device die onto the circuit substrate to form a circuit assembly, the semiconductor device die including one or more cavities aligned with the one or more protrusions, each cavity plated with a third material having a third melt temperature that is greater than the second melt temperature; and heating the circuit assembly at a selected temperature that is greater than or equal to the second melt temperature and that is less than the first and third melt temperatures to reflow the second material to form an intermetallic connection between the circuit substrate and the semiconductor device die to form a circuit device.

Example 2: The method of Example 1, where the first material includes at least one of Copper, Gold, Tin, Nickel, Palladium, Aluminum, and a Copper alloy plated with one or more of Nickel, Palladium, Gold, and Tin.

Example 3: The method of any of the preceding Examples, where the second material includes at least one of Gallium, Indium, and Bismuth.

Example 4: The method of any of the preceding Examples, where the third material includes at least one of Copper, Gold, Tin, Nickel, Palladium, Aluminum, and a Copper alloy plated with one or more of Nickel, Palladium, Gold, and Tin..

Example 5: The method of any of the preceding Examples, where the first melt temperature and the third melt temperature are greater than two hundred degrees Celsius.

Example 6: The method of any of the preceding Examples, where the second melt temperature is within a range from one hundred degrees Celsius to two hundred degrees Celsius.

Example 7: The method of any of the preceding Examples, where, at a later time, the method includes applying localized heat to an interface between the circuit substrate and the semiconductor device die of the circuit device; and applying mechanical force to separate the semiconductor device die from the circuit substrate.

Example 8: The method of Example 7, further comprising pressing the semiconductor device die onto a second circuit substrate to form a second circuit assembly.

Example 9: The method of any of the preceding Examples, where providing the circuit substrate includes forming the circuit substrate including a first surface having a plurality of contact pads; and forming the one or more protrusions, each protrusion formed on one of the plurality of contact pads.

Example 10: The method of any of the preceding Examples, where each protrusion includes a first portion including a proximal end coupled to the active surface and including a distal end; and a second portion coupled to the distal end of the first portion.

Example 11: The method of Example 10, where the first portion has a first shape and the second portion has a second shape.

Example 12: The method of Example 11, where the first shape has one of a conical shape, a cylindrical shape, a rectangular shape, a circular shape, a pyramidal shape; and the second shape has a hemispherical shape.

Example 13: The method of Example 11, where the second shape is smaller relative to the first shape.

Example 14: The method of any of the preceding Examples, further includes forming the one or more cavities in the first surface of the semiconductor device die; and plating each of the one or more cavities with the third material.

Example 15: A circuit device includes a circuit substrate including an active surface including one or more protrusions, each protrusion formed from a first material having a first melt temperature; a second material coated onto each of the one or more protrusions, the second material having a second melt temperature that is less than the first melt temperature; a semiconductor device die including one or more cavities, each cavity plated with a third material having a third melt temperature that is greater than the second melt temperature, the semiconductor device coupled to the one or more protrusions by an intermetallic connection formed by reflow of the second material; where the second melt temperature is within a first range of one hundred degrees Celsius to two hundred degrees Celsius; and where the first melt temperature is greater than two hundred degrees Celsius.

Example 16: The circuit device of Example 15, where the first material and the third material are selected from a group consisting of Copper, Gold, Tin, Nickel, Palladium, Aluminum, and a Copper alloy plated with one or more of Nickel, Palladium, Gold, and Tin.; and the second material is selected from a group consisting of Gallium, Indium, and Bismuth.

Example 17: The circuit device of Example 15, where each of the cavities is sized to receive one of the protrusions.

Example 18: A method includes providing a circuit substrate including an active surface including one or more protrusions, each protrusion formed from a first material having a first melt temperature; coating each of the one or more protrusions with a second material having a second melt temperature that is less than the first melt temperature; pressing a semiconductor device die onto the circuit substrate to form a circuit assembly, the semiconductor device die including one or more cavities aligned with and sized to receive the one or more protrusions, each cavity plated with a third material having a third melt temperature that is greater than the second melt temperature; and heating the circuit assembly at a selected temperature that is greater than or equal to the second melt temperature and that is less than the first and third melt temperatures to reflow the second material to form an intermetallic connection between the circuit substrate and the semiconductor device die to form a circuit device; and where the first material is selected from a group consisting of Copper, Gold, Tin, Nickel, Palladium, Aluminum, and a Copper alloy plated with one or more of Nickel, Palladium, Gold, and Tin.; the second material is selected from a group consisting of Gallium, Indium, and Bismuth; and the third material is selected from a group consisting of Copper, Gold, Tin, Nickel, Palladium, Aluminum, and a Copper alloy plated with one or more of Nickel, Palladium, Gold, and Tin..

Example 19: The method of Example 18, where the first melt temperature and the third melt temperature are greater than two hundred degrees Celsius; and the second melt temperature is within a range from one hundred degrees Celsius to two hundred degrees Celsius.

Example 20: The method of Example 18 or 19, where, at a later time, the method includes applying localized heat to an interface between the circuit substrate and the semiconductor device die of the circuit device; applying mechanical force to separate the semiconductor device die from the circuit substrate; and subsequently pressing the semiconductor device die onto a second circuit substrate to form a second circuit assembly.

The preceding detailed description is merely illustrative in nature and is not intended to limit the embodiments of the subject matter or the application and uses of such embodiments. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A method comprises:
providing a circuit substrate (202) including an active surface including one or more protrusions (204), each protrusion formed from a first material having a first melt temperature;
coating each of the one or more protrusions with a second material (214) having a second melt temperature that is less than the first melt temperature;
pressing a semiconductor device die (222) onto the circuit substrate to form a circuit assembly, the semiconductor device die including one or more cavities (224) aligned with the one or more protrusions, each cavity plated with a third material (228) having a third melt temperature that is greater than the second melt temperature; and
heating the circuit assembly at a selected temperature that is greater than or equal to the second melt temperature and that is less than the first and third melt temperatures to reflow the second material to form an intermetallic connection between the circuit substrate and the semiconductor device die to form a circuit device.

2. The method of claim 1, wherein the first material comprises at least one of Copper, Gold, Tin, Nickel, Palladium, Aluminum, and a Copper alloy plated with one or more of Nickel, Palladium, Gold, and Tin.

3. The method of claim 1 or 2, wherein the second material comprises at least one of Gallium, Indium, and Bismuth.

4. The method of claim 1, wherein the third material comprises at least one of Copper, Gold, Tin, Nickel, Palladium, Aluminum, and a Copper alloy plated with one or more of Nickel, Palladium, Gold, and Tin.

5. The method of any of the preceding claims, wherein the first melt temperature and the third melt temperature are greater than two hundred degrees Celsius.

6. The method of any of the preceding claims, wherein the second melt temperature is within a range from one hundred degrees Celsius to two hundred degrees Celsius.

7. The method of any of the preceding claims, wherein, at a later time, the method comprises:
applying localized heat to an interface between the circuit substrate and the semiconductor device die of the circuit device; and
applying mechanical force to separate the semiconductor device die from the circuit substrate.

8. The method of any of the preceding claims, further comprising pressing the semiconductor device die onto a second circuit substrate to form a second circuit assembly.

9. The method of any of the preceding claims , wherein providing the circuit substrate comprises:
forming the circuit substrate including a first surface having a plurality of contact pads (206); and
forming the one or more protrusions, each protrusion formed on one of the plurality of contact pads.

10. The method of any of the preceding claims, wherein each protrusion comprises:
a first portion including a proximal end coupled to the active surface and including a distal end; and
a second portion coupled to the distal end of the first portion.

11. The method of claim 10, wherein:
the first portion has a first shape comprising one of a conical shape, a cylindrical shape a rectangular shape, a circular shape, a pyramidal shape; and
the second portion has a second shape that is smaller than the first shape.

12. The method of any of the preceding claims, further comprising:
forming the one or more cavities in a first surface of the semiconductor device die; and
plating each of the one or more cavities with the third material.

13. A circuit device comprising:
a circuit substrate (202) including an active surface including one or more protrusions (204), each protrusion formed from a first material having a first melt temperature;
a second material (214) coated onto each of the one or more protrusions, the second material having a second melt temperature that is less than the first melt temperature;
a semiconductor device die (222) including one or more cavities (224), each cavity plated with a third material (228) having a third melt temperature that is greater than the second melt temperature, the semiconductor device coupled to the one or more protrusions by an intermetallic connection formed by reflow of the second material;
wherein the second melt temperature is within a first range of one hundred degrees Celsius to two hundred degrees Celsius; and
wherein the first melt temperature is greater than two hundred degrees Celsius.

14. The circuit device of claim 13, wherein:
the first material and the third material are selected from a group consisting of Copper, Gold, Tin, Nickel, Palladium, Aluminum, and a Copper alloy plated with one or more of Nickel, Palladium, Gold, and Tin; and
the second material is selected from a group consisting of Gallium, Indium, and Bismuth.

15. The circuit device of claim 13 or 14, wherein each of the cavities is sized to receive one of the protrusions.
